Europäisches Patentamt

**European Patent Office**

**Office européen des brevets**

(19)

(11) Numéro de publication : **0 028 181**
**B1**

(12)

# FASCICULE DE BREVET EUROPÉEN

(45) Date de publication du fascicule du brevet :
**16.02.83**

(51) Int. Cl.³ : **H 03 F   1/32, H 04 N   5/38**

(21) Numéro de dépôt : **80401466.0**

(22) Date de dépôt : **14.10.80**

(54) **Dispositif de précorrection en haute fréquence de la non-linéarité des amplificateurs de signaux comportant au moins un signal porteur modulé en amplitude, et émetteur de télévision comportant un tel dispositif.**

(30) Priorité : **26.10.79 FR 7926607**

(43) Date de publication de la demande :
**06.05.81 Bulletin 81/18**

(45) Mention de la délivrance du brevet :
**16.02.83 Bulletin 83/07**

(84) Etats contractants désignés :
**DE GB IT**

(56) Documents cités :
**DE A 2 306 294**
**FR A 2 146 889**
**FR A 2 312 152**
**GB A 1 419 519**

(73) Titulaire : **THOMSON-CSF**
**173, Boulevard Haussmann**
**F-75379 Paris Cedex 08 (FR)**

(72) Inventeur : **Ta-Hong, Anh**
**"THOMSON-CSF" SCPI 173, Bld Haussmann**
**F-75360 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

Jouve, 18, rue St-Denis, 75001 Paris, France

Dispositif de précorrection en haute fréquence de la non-linéarité des amplificateurs de signaux comportant au moins un signal porteur modulé en amplitude, et émetteur de télévision comportant un tel dispositif

La présente invention concerne les dispositifs de précorrection de la non-linéarité des amplificateurs de puissance de signaux comportant au moins un signal porteur modulé en amplitude par des signaux de modulation couvrant une large gamme de fréquences, les amplificateurs ayant une largeur de bande dissymétrique par rapport à la fréquence du signal porteur, de sorte qu'ils n'amplifient de manière sensiblement identique les deux bandes latérales de modulation que jusqu'à une certaine fréquence de modulation, au-delà de laquelle une seule bande latérale est normalement amplifiée, comme c'est généralement le cas des amplificateurs de puissance des émetteurs de télévision.

En effet, tous les standards de télévision prévoient la transmission en bande latérale unique des signaux de modulation vidéofréquence à partir d'une certaine fréquence, voisine généralement de 2MHz, et tous les utilisateurs cherchent à optimiser la puissance des amplificateurs en leur donnant une largeur de bande limitée au spectre à transmettre.

Mais ces amplificateurs ne présentent pas une courbe de transfert linéaire et, en particulier, se saturent aux niveaux élevés.

Il est connu de corriger ce défaut à l'aide d'un précorrecteur constitué d'un quadripôle non linéaire auquel il est donné une courbe de transfert complémentaire de celle de l'amplificateur à corriger, voir par exemple la demande de brevet DE-A 2 306 294. Un tel précorrecteur est inséré, soit dans le circuit de modulation de l'émetteur, soit dans les circuits haute fréquence, généralement en fréquence intermédiaire.

Cette dernière solution serait la mieux adaptée à ce type de précorrection, si les circuits sélectifs de l'amplificateur transmettaient entièrement les deux bandes latérales de modulation. Or, il a été dit ci-avant que ce n'est généralement pas le cas, notamment pour les amplificateurs à klystron dont les cavités d'entrée, de surtension élevée, atténuent fortement la bande latérale atténuée.

Dans ces conditions, la non-linéarité de la courbe de transfert de ces amplificateurs entraîne certaines conséquences :

Si on mesure la distorsion d'un signal de modulation d'essai normalisé, comportant des escaliers de luminance auquel on superpose un petit signal de fréquence élevée, il est constaté une distorsion importante sur les écarts d'amplitude des marches de l'escalier mais de faibles variations du gain différentiel du petit signal. Ceci peut s'expliquer par le fait que, toutes choses égales par ailleurs, le niveau de crête de modulation est de quelques 2,5 dB plus élevé pour les signaux de fréquence basse transmis en double bande de modulation que pour les signaux de fréquence élevée transmis sensiblement en bande latérale unique.

Il en résulte notamment l'impossibilité de trouver un seul et même réglage du précorrecteur pour corriger toutes les conséquences de la distorsion de l'amplificateur. En particulier, il y a incompatibilité entre la correction de la courbe de transfert et celle des produits d'intermodulation.

La présente invention a pour but de pallier ces inconvénients.

Selon l'invention, un dispositif de précorrection en haute fréquence destiné à corriger la non-linéarité d'un amplificateur, amplifiant au moins un signal porteur modulé en amplitude, et ayant une largeur de bande totale B dissymétrique par rapport au signal porteur, B étant égal à $B_1 + B_2$ où $B_1$ est la partie de la bande sensiblement symétrique par rapport au signal porteur et $B_2$ le reste de la bande, le dispositif comportant au moins un quadripôle ayant une courbe de transfert, au moins en partie, complémentaire de celle de l'amplificateur, est caractérisé en ce que le quadripôle est précédé et suivi respectivement d'un premier et d'un second filtre passe bande, chacun des deux filtres ayant deux bandes passantes distinctes, contiguës et de largeurs respectivement égales sensiblement à $B_1$ et $B_2$, entre lesquelles chaque filtre présente un écart de perte d'insertion moyenne, ces écarts ayant des valeurs opposées pour le premier et pour le second filtre.

L'invention a également pour objet un émetteur de télévision comportant un tel dispositif.

L'invention sera mieux comprise et d'autres caractéristiques apparaîtront à l'aide de la description ci-après et des dessins s'y rapportant sur lesquels :

la figure 1 est un bloc diagramme d'un émetteur de télévision à dispositif de précorrection selon l'art connu ;

la figure 2 est un mode de réalisation selon l'invention du dispositif de précorrection de la figure 1 ;

les figures 3a, 3b, 3c, 3d et 3f représentent des diagrammes explicatifs.

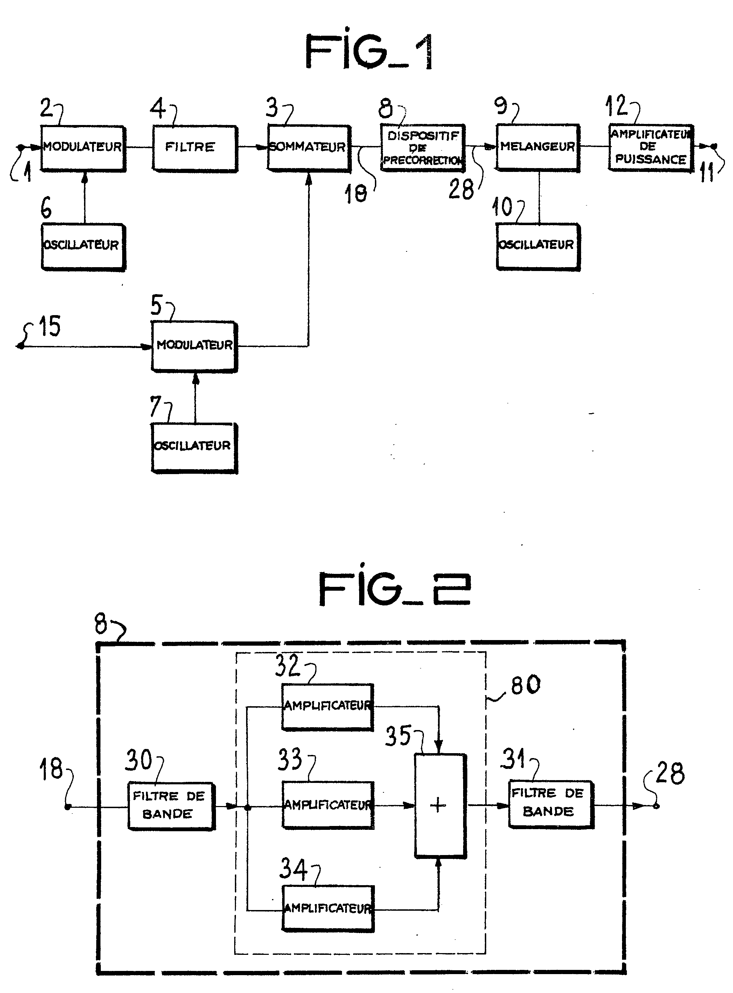

Sur la figure 1, une borne d'entrée 1, destinée à recevoir des signaux vidéofréquence, est connectée à une première entrée d'un modulateur 2 dont une deuxième entrée est reliée à un oscillateur à fréquence intermédiaire 6, et la sortie, connectée à une première entrée d'un sommateur 3, à travers un filtre 4. Une borne d'entrée 15 destinée à recevoir des signaux audiofréquence est connectée à une seconde entrée du sommateur 3 à travers un modulateur 5 dont une entrée est reliée à un oscillateur à fréquence intermédiaire 7. La sortie 18 du sommateur 3 est reliée, à travers un dispositif de précorrection 8, à une des entrées 28 d'un mélangeur 9 dont l'autre entrée est couplée à la sortie d'un oscillateur 10, et la sortie est connectée à la borne de sortie 11 à travers un amplificateur de puissance à klystron 12.

Le schéma décrit est celui d'un émetteur de télévision classique, à voie commune d'amplification de puissance, par klystron, pour le son et l'image. Le dispositif de précorrection en fréquence intermédiaire, 8, est un quadripôle dont la fonction de transfert est complémentaire de celle de l'amplificateur afin de corriger non seulement les défauts de non-linéarité en fréquence, dans tous les spectres vidéofréquence, mais ceux d'intermodulation, d'ordre trois notamment.

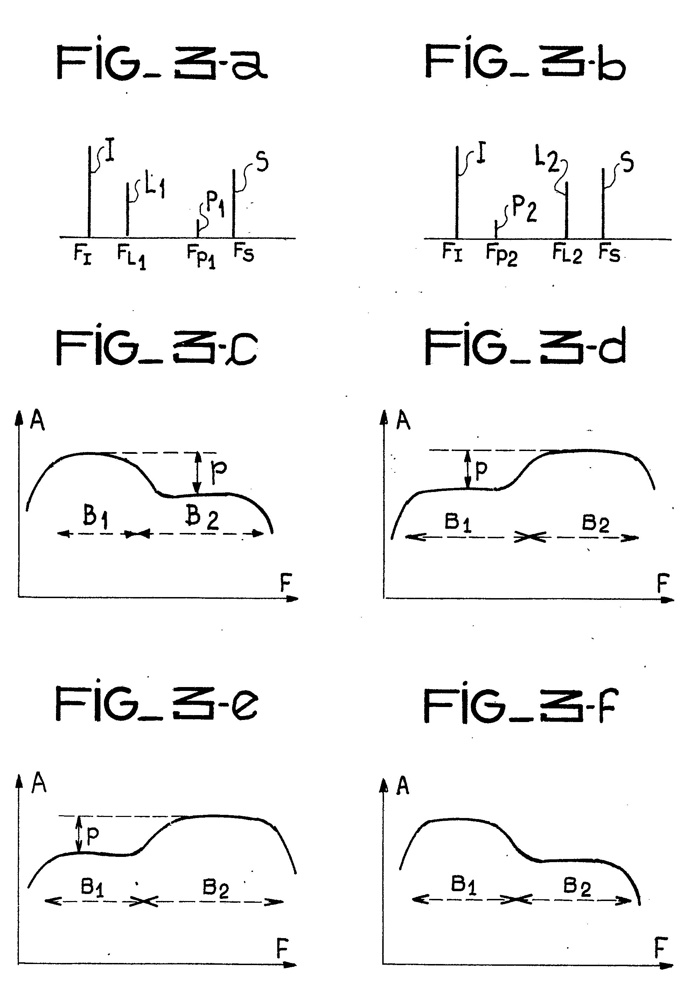

Sur la figure 3a est représenté un spectre de fréquences comportant la porteuse image I de fréquence $F_I$, la porteuse son S de fréquence $F_S$ supposée supérieure à $F_I$, une composante de bande latérale vidéofréquence, $L_1$, de fréquence $F_{L_1}$, et un produit d'intermodulation parasite $P_1$, de fréquence $F_{P_1}$. Ce dernier, le plus important tombant dans la bande de fréquences amplifiées, est donné par $F_{P_1} = F_S - (F_{L_1} - F_I)$. Mais $F_{L_1} - F_I = F_M$, fréquence de modulation correspondante de la porteuse I, ainsi $F_S - F_P = F_M$. La figure 3a représente le cas où $F_M$ est une fréquence basse (< 2 MHz) c'est-à-dire où l'autre bande latérale, non représentée, ne sera pas sensiblement atténuée par l'amplificateur 12. Par contre, la figure 3b représente le cas où $F_M$ est supérieure à 2 MHz et voisine de la fréquence de modulation maximale, d'où une nouvelle composante de bande latérale $L_2$ et un produit d'intermodulation $P_2$.

Avec un tel dispositif de précorrection, il est constaté l'impossibilité d'obtenir simultanément, pour une courbe de transfert donnée du dispositif 8, une bonne linéarité et un faible niveau d'intermodulation, à la fois pour la partie basse et pour la partie haute du spectre vidéofréquence.

Un exemple de réalisation d'un dispositif de précorrection 8 selon l'invention est montré sur la figure 2. Il associe à un quadripôle 80 non linéaire de gain variable des filtres de caractéristiques déterminées.

Sur la figure 2, où les mêmes repères que sur la figure précédente désignent les mêmes organes, les entrées de trois amplificateurs 32 à 34 sont connectées à la borne d'entrée 18, à travers un filtre de bande 30, et leurs sorties alimentent respectivement les trois entrées d'un sommateur 35 dont la sortie est connectée à la sortie 28 du dispositif à travers un filtre de bande 31.

Les amplificateurs 32 et 33 possèdent chacun un seuil d'amplification de niveau réglable ainsi qu'un gain ajustable. L'amplificateur 34 est au contraire linéaire et de gain fixé une fois pour toutes. Le sommateur 35 additionne en phase les tensions de sortie de ces trois amplificateurs. L'ensemble des organes 32 à 35 constitue ainsi un quadripôle non linéaire de gain croissant avec le niveau de signal d'entrée au fur et à mesure de l'engagement des seuils successifs des amplificateurs 32 et 33. Un réglage approprié de la valeur des seuils et des gains permet d'obtenir aisément une courbe de transfert complémentaire de celle du klystron amplificateur 12. Un tel quadripôle est bien connu, il constitue, par exemple, le dispositif de précorrection 8 de la figure 1. Mais il est ici précédé et suivi respectivement des filtres 30 et 31 qui sont complémentaires, c'est-à-dire que la fonction de transfert de l'ensemble des deux filtres, supposés connectés directement en série, est plate.

Les figures 3c et 3d représentent respectivement les courbes de l'amplitude A en fonction de la fréquence F du signal traversant les filtres, respectivement 30 et 31.

Le filtre 30 présente une perte d'insertion moyenne inférieure sur une première partie $B_1$ de sa bande par rapport à celle d'une seconde partie $B_2$, l'écart p étant égal à 3 dB. $B_1$ correspond sensiblement à la largeur de bande occupée par le spectre de modulation d'amplitude par les signaux vidéofréquences, transmis sans atténuation sensible d'une des deux bandes latérales par l'amplificateur 12. $B_2$ correspond au reste du spectre transmis, soit essentiellement la porteuse son et ses bandes latérales, et la partie du spectre de modulation, par les signaux vidéofréquence, transmise avec une bande latérale atténuée. Le filtre 31 présente évidemment des variations de perte d'insertion inverses de celles du filtre 30.

Ces filtres sont de réalisation simple, les transitions étant très douces de manière à éviter des rotations de phase intempestives qui compromettraient les compensations attendues. Dans l'exemple décrit, ils consistent chacun en un filtre de bande constitué de deux circuits oscillants couplés, dont les accords respectifs et dont le couplage sont ajustés pour obtenir des courbes telles que les figures 3c et 3d.

Il résulte de ces dispositions que la partie du spectre de largeur de bande $B_1$ sera plus engagée que le reste du spectre dans les seuils du quadripôle non linéaire ; elle sera affectée d'une précorrection plus importante correspondant à la distorsion également plus importante générée par l'amplificateur de puissance, comme cela a été expliqué ci-avant.

Il est réalisé ainsi une précorrection à caractère sélectif qui peut être poussée jusqu'à obtenir des réglages largement indépendants pour chacun des spectres occupant respectivement les bandes $B_1$ et $B_2$. Il suffit pour cela de donner à p une valeur plus élevée et de prévoir un deuxième dispositif de précorrection identique à celui décrit mais où les bandes des filtres 30 et 31 sont interverties afin d'obtenir respectivement les courbes représentées sur les figures 3c et 3f.

L'indépendance des réglages de chaque quadripôle peut être particulièrement mise en évidence sur les raies parasites d'intermodulation, l'expérience montre que les réglages du premier quadripôle cité agissent essentiellement sur le niveau de la raie parasite $P_1$ (figure 3a) et ceux du second (c'est-à-dire avec les filtres inversés) sur le niveau de la raie parasite $P_2$ (figure 3b).

Tout ce qui vient d'être dit concernant la précorrection de non-linéarité d'un amplificateur à klystron peut s'appliquer à un amplificateur de puissance à tubes, par exemple des tétrodes, aux variantes suivantes près :

La fonction de transfert d'un tel amplificateur montre, comme pour le klystron, une saturation aux fréquences élevées, corrigible par le même dispositif. Mais son allure générale est celle d'un S c'est-à-dire qu'elle présente également un coude pour les niveaux faibles, région où le gain de l'amplificateur croît avec le niveau d'entrée.

Il est donc nécessaire de prévoir en plus un ensemble de précorrection tel que décrit mais avec des quadripôles non linéaires présentant une fonction de transfert d'allure inverse.

En réalité, les tubes atténuent la bande latérale atténuée beaucoup moins que les klystrons et il est suffisant de prévoir, pour le coude inférieur de la caractéristique, un quadripôle non linéaire seul, tel que cela est déjà connu, et pour les niveaux élevés, qui provoquent la saturation, un seul dispositif de précorrection tel que celui de la figure 2.

Les dispositifs décrits s'appliquent non seulement aux émetteurs à voie commune image et son mais aussi aux émetteurs à voies séparées. On obtient ainsi facilement une bonne linéarité, homogène sur toute l'étendue du spectre vidéofréquence.

## Revendications

1. Dispositif de précorrection en haute fréquence destiné à corriger la non-linéarité d'un amplificateur (12), amplifiant au moins un signal porteur modulé en amplitude, et ayant une largeur de bande totale B dissymétrique par rapport au signal porteur, B étant égal à $B_1 + B_2$, où $B_1$ est la partie de la bande sensiblement symétrique par rapport au signal porteur et $B_2$ le reste de la bande, le dispositif (8) comportant au moins un quadripôle (80) ayant une courbe de transfert, au moins en partie, complémentaire de celle de l'amplificateur (12), caractérisé en ce que le quadripôle (80) est précédé et suivi respectivement d'un premier et d'un second filtre passe bande (30 et 31), chacun des deux filtres ayant deux bandes passantes distinctes, contiguës, et de largeurs respectivement égales sensiblement à $B_1$ et $B_2$ entre lesquelles chaque filtre présente un écart P de perte d'insertion moyenne, ces écarts P ayant des valeurs opposées pour le premier et pour le second filtre.

2. Dispositif de précorrection selon la revendication 1, caractérisé en ce que le quadripôle (80) a une courbe de transfert complémentaire de celle de l'amplificateur (12) pour les signaux modulés de grande amplitude, le premier filtre (30) ayant, dans la bande $B_1$ une perte d'insertion inférieure à celle de la bande $B_2$.

3. Dispositif de précorrection selon la revendication 2, caractérisé en ce qu'il comporte en outre un quadripôle complémentaire de même type que le quadripôle (80) déjà cité et qui est précédé et suivi respectivement d'un premier et d'un deuxième filtre passe bande complémentaires, chacun des deux filtres ayant deux bandes passantes distinctes, contiguës, et de largeurs respectivement égales sensiblement à $B_1$ et $B_2$, le premier filtre complémentaire ayant dans la bande $B_1$ une perte d'insertion supérieure à celle

de la bande $B_2$ et inversement pour le second filtre.

4. Dispositif de précorrection selon l'une des revendications 1 ou 2, caractérisé en ce que l'écart P de perte d'insertion est sensiblement égal à 3dB.

5. Dispositif de précorrection selon l'une des revendications 1 à 4, caractérisé en ce que le quadripôle (80) comporte un amplificateur linéaire (34) et au moins un amplificateur à seuil d'amplification et gain réglables (32, 33), ces derniers amplificateurs ayant chacun une entrée alimentée par les signaux à précorriger et une sortie couplée à un sommateur (35)

6. Emetteur de télévision caractérisé en ce qu'il comporte un dispositif de précorrection (8) selon l'une des revendications 1 à 5.

## Claims

1. A high-frequency pre-correcting device for correcting the non-linearity of an amplifier, amplifying at least one amplitude-modulated carrier signal, and having a total band width B, dissymmetric with respect to the carrier signal, B being equal to $B_1 + B_2$, wherein $B_1$ is that portion of the band which is substantially symmetric with respect to the carrier signal, and $B_2$ is the remaining portion of said band, said device (8) comprising at least one four-pole (80) having, at least in part, a transfer curve complementary to that of the amplifier (12), characterized in that said four-pole (80) is preceded and followed, respectively, by a first and second pass-band filter (30 and 31), each one of said filters having two distinct contiguous pass-bands the respective widths of which are substantially equal to $B_1$ and $B_2$, respectively, and between which each filter has a mean insertion loss interval P, said intervals P having mutually opposed values for said first and second filters.

2. A pre-correcting device according to claim 1, characterized in that said four-pole (80) has a transfer curve complementary to that of the amplifier (12) for the modulated high-amplitude signals, said first filter (30) having in said $B_1$ band an insertion loss smaller than that of said $B_2$ band.

3. A pre-correcting device according to claim 2, characterized in that it further comprises a complementary four-pole of the same type as the previously mentioned four-pole (80), which is preceded and followed, respectively, by a first and a second complementary pass-band filter, each one of said two filters having two distinct contiguous pass-bands the widths of which are substantially equal to $B_1$ and $B_2$, respectively, said first complementary filter having in the $B_1$ band an insertion loss higher than that of the $B_2$, and inversely for the second filter.

4. A pre-correcting device according to any one of claims 1 or 2, characterized in that the insertion loss difference P is substantially equal to 3 dB.

5. A pre-correcting device according to any one of claims 1 to 4, characterized in that said four-pole (80) comprises a linear amplifier (34) and at least one amplifier having an adjustable amplifying threshold and gain (32, 33), these last amplifiers having each an input fed with the signals to be precorrected, and an output coupled to a summarizer (35).

6. A television emitter, characterized in that it comprises a precorrecting device (8) according to any one of claims 1 to 5.

**Ansprüche**

1. Hochfrequenz-Präkorrekturvorrichtung (8) zur Berichtigung der Nichtlinearität eines Verstärkers (12) für die Verstärkung wenigstens eines Trägersignals mit einer in bezug auf das Trägersignal asymmetrischen Gesamtbandbreite B, wobei B gleich $B_1 + B_2$ ist und $B_1$ den in bezug auf das Trägersignal wesentlich symmetrischen Teil des Bandes und $B_2$ den restlichen Teil des Bandes darstellt, mit wenigstens einem Vierpol (80), dessen Transferverlauf wenigstens teilweise demjenigen des Verstärkers (12) entspricht, dadurch gekennzeichnet, dass dem Vierpol (80) je ein Bandfilter (30 und 31) vor = bzw. nachgeschaltet ist, wobei jeder der beiden Filter zwei verschiedene benachbarte Durchlassbereiche besitzt, deren Bandbreite wesentlich $B_1$ bzw. $B_2$ entspricht und zwischen welchen jeder Filter eine mittlere Insertionsverlustdifferenz P aufweist, und wobei diese Differenzen P beim ersten und zweiten Filter einander entgegengesetzte Werte haben.

2. Präkorrektionsvorrichtung nach Anspruch 1, dadurch gekennzeichnet, dass der Vierpol (80) eine Transferkurve besitzt, die in bezug auf diejenige des Verstärkers (12) für die modulierten Signale mit grosser Amplitude komplementär ist, wobei der erste Filter (30) im Band $B_1$ einen Insertionsverlust besitzt, welcher kleiner ist als derjenige des Bandes $B_2$.

3. Präkorrektionsvorrichtung nach Anspruch 1, dadurch gekennzeichnet, dass er ferner einen zusätzlichen Vierpol vom gleichen Typ wie der vorgenannte Vierpol (80) besitzt, wobei diesem zusätslichen Vierpol ein erster zusätzlicher Filter und ein zweiter zusätzlicher Filter vor = bzw. nachgeschaltet ist und jeder dieser beiden Filter zwei verschiedene benachbarte Passbänder besitzt, deren jeweilige Bandbreite wesentlich $B_1$ bzw. $B_2$ gleich ist, während der erste zusätzliche Filter im $B_1$-Band einen Insertionsverlust aufweist, welcher höher als derjenige des $B_2$-Bandes ist, und während beim zweiten Filter dieses Verhältnis umgekehrt ist.

4. Präkorrektionsvorrichtung nach Anspruch 1 oder 2, dadurch gekennzeichnet, dass die Insertionsdifferenz wesentlich 3 dB beträgt.

5. Präkorrektionsvorrichtung nach einem der Ansprüche 1 bis 4, dadurch gekennzeichnet, dass der Vierpol (80) einen Linearverstärker (34), sowie wenigstens einen Verstärker mit einstellbarer Verstärkungsschwelle und Verstärkung (32, 33) aufweist, wobei diese letzteren Verstärker je einen mit den zu präkrorrigierenden Signalen gespeisten Eingang und einen mit einem Summiergerät (35) gekoppelten Ausgang aufweisen.

6. Fernsehsender, dadurch gekennzeichnet, dass er eine Präkorrektionsvorrichtung (8) nach einem der Ansprüche 1 bis 5 aufweist.

# FIG_1

# FIG_2

# FIG_3-a

$I$

$L_1$

$P_1$

$S$

$F_I$  $F_{L_1}$  $F_{P_1}$  $F_S$

# FIG_3-b

$I$

$L_2$

$P_2$

$S$

$F_I$  $F_{P_2}$  $F_{L_2}$  $F_S$

# FIG_3-c

$A$

$P$

$B_1$  $B_2$

$F$

# FIG_3-d

$A$

$P$

$B_1$  $B_2$

$F$

# FIG_3-e

$A$

$P$

$B_1$  $B_2$

$F$

# FIG_3-f

$A$

$B_1$  $B_2$

$F$